# EUROPÄISCHE PATENTSCHRIFT

(11) **EP 1 709 853 B1**
(45) Veröffentlichungstag und Bekanntmachung des Hinweises auf die Patenterteilung: **13.08.2008**
(21) Anmeldenummer: 03789148.8
(22) Anmeldetag: 05.12.2003
(51) Int. Cl.: H05K 7/20

(54) **KÜHLEINRICHTUNG FÜR ELEKTRISCHE LEISTUNGSEINHEITEN VON ELEKTRISCH BETRIEBENEN FAHRZEUGEN**
COOLING DEVICE FOR ELECTRICAL POWER UNITS OF ELECTRICALLY OPERATED VEHICLES
DISPOSITIF POUR REFROIDIR DES BLOCS D'ALIMENTATION ELECTRIQUE POUR VEHICULES ELECTRIQUES

(43) Veröffentlichungstag der Anmeldung: 11.10.2006
(73) Patentinhaber: Renk Aktiengesellschaft, 86159 Augsburg (DE)
(72) Erfinder: WALTER, Alexander, 86161 Augsburg (DE)
(74) Vertreter: Schlotter, Alexander Carolus Paul
(86) Internationale Anmeldenummer: PCT/EP2003/013797
(87) Internationale Veröffentlichungsnummer: WO 2005/055687

(56) Entgegenhaltungen:
- EP-A- 1 253 814
- DE-A- 2 757 282
- DE-A- 4 436 547
- US-A1- 2003 133 267

## Beschreibung

Die Erfindung betrifft eine Kühleinrichtung für elektrische Leistungseinheiten von elektrisch betriebenen Fahrzeugen gemäß dem Patentanspruch 1.
Es ist allgemein bekannt Fahrzeuge mit elektrischen Fahrantrieben auszustatten. Aus der DE 37 28 171 C2 ist beispielsweise eine elektrische mechanische Antriebsanlage für ein Vollkettenfahrzeug bekannt. Es ist mindestens ein elektrischer Fahrmotor und ein Lenkelektromotor vorgesehen, mit welchem die regenerative Lenkleistung von einer zur anderen Antriebsseite mechanisch übertragen werden kann.
Aus der EP 1 060 941 B1 ist eine Einrichtung für die Ansteuerung und Betrieb eines elektrischen Fahrzeugantriebs bekannt. Bei dieser Antriebsanordnung ist für jede Antriebsseite ein eigener elektrischer Antriebsmotor vorgesehen.
Für die Versorgung der Elektromotoren mit elektrischem Strom für den Antrieb solcher Fahrzeuge sind in der Regel - von Brennkraftmaschinen angetriebene - Stromgeneratoren vorgesehen. Der elektrische Strom wird über entsprechende Leistungseinheiten auf die Elektromotoren übertragen. Solche Leistungseinheiten bestehen aus einem Leistungsteil und einem Steuerungsteil, welche zu einer kompakten Baueinheit zusammengefasst sind. Entsprechend der übertragenen Leistung erwärmen sich die Leistungseinheiten und müssen zum Schutz ihrer Bauteile vor Überhitzung gekühlt werden. In den Leistungsteilen werden Leistungen übertragen, die um 1 bis 4 Zehnerpotenzen (10 bis 10⁴) größer sind als in den Steuerungsteilen.
Die eingesetzten einkreisigen Kühlsysteme müssen auf die niedrigeren maximal zulässigen Temperaturen der Steuerungselektronik ausgelegt werden. Um damit auch die, in den Leistungsteilen anfallende, große Wärme mit der geringen Kühlleistung einer solchen Niedertemperaturkühlung abführen zu können, sind große Wärmetauscher mit entsprechend großen Mengen an Kühlmitteln erforderlich.

Aus der US 2003/0133267 ist eine Kühleinrichtung zur Verwendung in einem elektrischen Fahrzeug bekannt, welche ein Leistungsteil und ein davon separates Steuerteil umfasst. Das Leistungsteil ist auf einem Kühlkörper montiert, welcher mit einem ersten Kühlkreislauf verbunden ist. Das separate Steuerteil ist dabei mit einer Kühleinrichtung versehen, welche konduktiv Wärme an den Kühlkreislauf des Leistungsteils ableitet.

Hlervon ausgehend ist es die Aufgabe der Erfindung ein Kühlsystem zu schaffen, mit welchem sowohl das Steuerungsteil als auch das Leistungsteil ausreichend gekühlt werden können und kleinere Wärmetauscher ermöglicht.
Dlese Aufgabe wird erfindungsgemäß durch die kennzeichnenden Merkmale des Patentanspruchs 1 gelöst.
Durch die erfindungsgemäße Aufteilung des Kühlsystems In einen Nledertemperturkühlkreis mit geringer Leistung für die Steuerungselektronik und Hochtemperaturkühlkreis mit hoher Leistung für Leistungselektronik, können in vorteilhafter Weise kleinere Wärmetauscher eingesetzt werden.
Besonders vorteilhaft wirkt das erfindungsgemäße Kühlsystem bei elektrisch betriebenen Fahrzeugen, da es zur Verminderung des Gesamtgewichts des Antriebssystems beiträgt.

Weitere Merkmale und Vorteile ergeben sich aus den Unteransprüchen in Verbindung mit der Beschreibung.

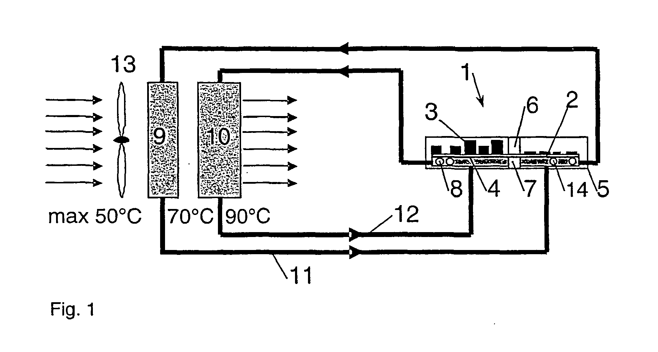

Die Erfindung wird nachfolgend anhand der zugehörigen schematischen Zeichnung näher erläutert. Die
Fig. 1 zeigt ein Blockschaltbild einer erfindungsgemäßen Kühleinrichtung.
In Fig. 1 ist eine elektrische Leistungseinheit 1 zur Stromversorgung eines Elektromotors für ein elektrisch betriebenes Fahrzeug dargestellt. Da sich die vorliegende Erfindung auf die Kühlung einer solchen Leistungseinheit 1 bezieht, sind die elektrischen Verkabelungen mit einer Energiequelle sowie dem zugehörigen Elektromotor und die Signalleitungen zwischen Bedienungseinrichtungen des Fahrzeuges, wie Fahrpedal, Lenkeinrichtung und ähnliches, mit der Leistungseinheit 1 nicht dargestellt.

Die beispielhaft dargestellte Leistungseinheit 1 ist auf einer Platine 4 in einem Gehäuse 5 angeordnet. Die in bekannter Weise aus einem Steuerungsteil 2 und einem Leistungsteil 3 bestehende Leistungseinheit 1 ist vorzugswelse so auf der Platine 4 angeordnet, dass das Steuerungsteil 2 und das Leistungsteil 3 jeweils mit ihren zusammengehörenden elektronischen Bauteilen einen eigenen Bereich auf der Platine 4 einnehmen.
Für das Steuerungsteil 2 ist ein erster Kühlkreislauf 11 mit einem Wärmetauscher 9 und für das Leistungsteil 3 ist ein weiterer Kühlkreislauf 12 mit einem Wärmetauscher 10 vorgesehen. Die Wärmetauscher 9, 10 sind für extreme Umgebungsbedingungen mit Umgebungstemperaturen von etwa 50 Grad Celsius ausgelegt. Hiervon ausgehend ist der Wärmetauscher 9 so auszulegen, dass sich für die empfindlicheren Bauteile des Steuerungsteils 2 eine Zulauftemperatur von etwa 70 Grad Celsius ergibt.
Für das Leistungsteil 3, welches ein mehrfaches an Leistung gegenüber dem Steuerungsteil 2 umsetzt, kann eine höhere Zulauftemperatur von etwa 90 Grad Celsius zugelassen werden. Aufgrund des physikalischen Zusammenhanges, dass der Wärmestrom proportional zum Produkt des Volumenstroms und der Temperaturdifferenz des Kühlmittels ist, erbringt der Wärmetauscher 10 mit der höheren Temperatur eine größere Kühlleistung. Der Wärmetauscher 10 kann daher bei gleichbleibender Kühlleistung im Vergleich mit einem Wärmetauscher mit einer niedrigeren Temperatur kleiner dimensioniert werden.
Aufgrund der höheren Kühlleistung des zweiten Wärmetauschers 10 für das Leistungsteil 3 und der - im Verhältnis zum Leistungsteil kleinen - Wärmemenge, welche vom Steuerungsteil 2 wegzuführen ist, ergibt sich für die beiden Wärmetauscher 9, 10 zusammen eine kleinere Baugröße als für einen einzigen Wärmetauscher, der mit der niedrigeren Temperatur beide Teile der Leistungseinheit zu kühlen hätte.
Die beiden Wärmetauscher 9, 10 werden vorzugsweise hintereinander angeordnet und zur Unterstützung der Kühlleistung kann zusätzlich ein Lüfter 13 vorgesehen werden.
Besonders vorteilhaft ist es, zwischen dem Leistungsteil 3 und dem Steuerungsteil 2, Trennwände 6, 7 vorzusehen, welche bis an die gemeinsame Platine 4 heranreichen und das Gehäuse 5 in zwei gegeneinander abgeschlossene Bereiche teilen. Die Trennwände 6, 7 werden bevorzugt aus einem thermisch isolierenden Werkstoff hergestellt.
Für die verschiedenen Kühlkreisläufe 11, 12 können im Gehäuse 5 und an den Trennwänden 6, 7 Kühlkanäle 8, 14 zur Führung des Kühlmittels vorgesehen werden.

Statt die Leistungseinheit 1 als kompakte Baugruppe herzustellen, ist es auch denkbar das Leistungsteil 3 und das Steuerungsteil 2 räumlich getrennt voneinander anzuordnen.

Im Allgemeinen gilt, dass die Bauelemente des Leistungsteils hohe Abwärme erzeugen aber auch hohe Umgebungstemperaturen ertragen können, während die Bauteile des Steuerteils eher wenig Abwärme erzeugen aber auch nur eine geringere Umgebungstemperatur ertragen können. Bei Ausnahmen von dieser Regel können durchaus auch typische Elemente des Leistungsteils im Bereich des Steuerungsteils platziert werden, wenn diese wenig Abwärme erzeugen oder nur niedere Umgebungstemperaturen aushalten. Genauso können auch typische Bauelemente des Steuerungsteils im Leistungsteil platziert werden, wenn diese hohe Umgebungstemperaturen aushalten. Es kann auch vorteilhaft sein die eigenständigen Baugruppen des Leistungsteils und Steuerungsteils als solche aufzulösen und neue Baugruppen zu bilden, deren Elemente nach der Wärme-Entwicklung und der Hitze-Empfindlichkeit zusammengestellt werden.

Der wesentliche Kern der vorliegenden Erfindung ist darin zu sehen, für die Kühlung einer elektrischen Leistungseinheit von elektrisch betriebenen Fahrzeugen zwei voneinander getrennte Kühlkreisläufe vorzusehen und die mit einer höheren Temperatur belastbaren Bauteile des Leistungsteils mit einem leistungsfähigeren Hochtemperatur-Kühlkreis zu kühlen. Aufgrund der besseren Kühlleistung des Hochtemperatur-Kühlkreises kann für die wesentlich größere Wärmemenge, die hauptsächlich aus dem Leistungsteil abzuführen ist ein kompakterer Wärmetauscher vorgesehen werden. Für die verhältnismäßig kleinen Wärmemengen aus dem Steuerungsteil kann auch mit niedrigerer Kühlmittel-Temperatur ein verhältnismäßig kleiner Wärmetauscher vorgesehen werden. In der Gesamtbilanz ergibt sich somit eine vorteilhafte Verkleinerung des Kühlsystems gegenüber einem einzigen Wärmetauscher, der mit niedriger Temperatur sowohl das Leistungs- als auch das Steuerungsteil kühlen muss.
Die Verkleinerung des Kühlsystems führt zu kleineren Wärmetauscherflächen und zu kleineren Kühlmittelmengen.

### Bezugszeichenliste

- 1: Leistungseinheit
- 2: Steuerungsteil
- 3: Leistungsteil
- 4: Platine
- 5: Gehäuse
- 6: Trennwand
- 7: Trennwand
- 8: Kühlkanal
- 9: Wärmetauscher
- 10: Wärmetauscher
- 11: Kühlkreislauf
- 12: Kühlkreislauf
- 13: Lüfter
- 14: Kühlkanal

## Patentansprüche

1. Kühleinrichtung für eine elektrische Leistungseinheit (1) von elektrisch betriebenen Fahrzeugen mit mindestens einem Leistungsteil (3) und mindestens einem Steuerungsteil (2) sowie einem ersten Kühlkreislauf (11) mit Wärmetauscher (9) mit niedriger Kühlmittel-Temperatur für die Kühlung von Elementen der Steuerungsteile (2) **dadurch gekennzeichnet, dass** ein weiterer Kühlkreislauf (12) mit einem weiteren Wärnetauscher (10) mit höherer Kühlmittel-Temperatur für die Kühlung von Elementen der Leistungsteile (3) vorgesehen ist.

2. Kühleinrichtung nach Anspruch 1, **dadurch gekennzeichnet, dass** das Leistungsteil (3) und das Steuerungsteil (2) auf einer gemeinsamen Platine (4) in einem gemeinsamen Gehäuse (5) angeordnet sind und zwischen dem Leistungsteil (3) und dem Steuerungsteil (2) mindestens eine Trennwand (6, 7) vorgesehen ist.

3. Kühleinrichtung nach Anspruch 2, **dadurch gekennzeichnet, dass** die Trennwände (6, 7) aus einem thermisch isolierenden Werkstoff bestehen.

4. Kühleinrichtung nach Anspruch 2 oder 3, **dadurch gekennzeichnet, dass** die Trennwände (6, 7) mit Kühlkanälen (8, 14) zur Führung von Kühlmittel versehen sind.

5. Kühleinrichtung nach einem der Ansprüche 2 bis 4, **dadurch gekennzeichnet, dass** das Gehäuse (5) mit Kühlkanälen (8, 14) zur Führung von Kühlmittel versehen ist.

6. Kühleinrichtung nach Anspruch 1, **dadurch gekennzeichnet, dass** das Leistungsteil (3) und das Steuerungsteil (2) räumlich voneinander getrennt angeordnet sind.

7. Kühleinrichtung nach einem der vorangehenden Ansprüche, **dadurch gekennzeichnet, dass** die Zulauftemperatur des Kühlmittels zum Leistungsteil (3) etwa 90 Grad Celsius und die Zulauftemperatur des Kühlmittels zum Steuerungsteil (2) etwa 70 Grad Celsius beträgt.

8. Kühleinrichtung nach einem der vorangehenden Ansprüche, **dadurch gekennzeichnet, dass** Elemente des Steuerungsteils im Bereich des Leistungsteils angeordnet sind und / oder Elemente des Leistungsteils im Bereich des Steuerungsteils angeordnet sind.

## Claims

1. Cooling device for an electrical power unit (1) of electrically operated vehicles comprising
at least one output component (3)
and at least one control component (2)
and a first cooling circuit (11) with a heat exchanger (9) having a low coolant temperature for cooling elements of the control components (2),
**characterized in that**
another cooling circuit (12) is provided with another heat exchanger (10) having a higher coolant temperature for cooling elements of the output components (3).

2. Cooling device according to claim 1, **characterized in that**
the output component (3) and the control component (2) are arranged on a shared circuit board (4) in a shared housing (5) and that at least one separating wall (6,7) is provided between the output component (3) and the control component (2).

3. Cooling device according to claim 2, **characterized in that**
the separating walls (6,7) are made from a thermally insulating material.

4. Cooling device according to claim 2 or 3, **characterized in that**
the separating walls (6,7) are provided with cooling ducts (8,14) for conducting a coolant.

5. Cooling device according to one of the claims 2 to 4, **characterized in that**
the housing (5) is provided with cooling ducts (8,14) for conducting a coolant.

6. Cooling device according to claim 1, **characterized in that**
the output component (3) and the control component (2) are arranged spatially apart.

7. Cooling device according to one of the above claims, **characterized in that**
the inlet temperature of the coolant for the output component (3) has approximately 90 degrees Celsius and the inlet temperature of the coolant for the control component (2) hat approximately 70 degrees Celsius.

8. Cooling device according to one of the above claims, **characterized in that** elements of the control component are arranged in the region of the output component and/or elements of the output component are arranged in the region of the control component.

## Revendications

1. Dispositif de refroidissement pour une unité de puissance électrique (1) de véhicules électriques comportant au moins une partie de puissance (3) et au moins une partie de commande (2) ainsi qu'un premier circuit de refroidissement (11) comportant un échangeur de chaleur (9) avec une température basse de moyen de refroidissement pour le refroidissement des éléments des parties de commande (2) **caractérisé en ce qu'**un autre circuit de refroidissement (12) est prévu avec un autre échangeur de chaleur (10) avec une température plus élevée de moyen de refroidissement pour le refroidissement des éléments des parties de puissance (3).

2. Dispositif de refroidissement selon la revendication 1, **caractérisé en ce que** la partie de puissance (3) et la partie de commande (2) sont disposées sur une platine commune (4) dans un boîtier commun (5) et au moins une paroi de séparation (6, 7) est prévue entre la partie de puissance (3) et la partie de commande (2).

3. Dispositif de refroidissement selon la revendication 2, **caractérisé en ce que** les parois de séparation (6, 7) sont constituées d'un matériau thermiquement isolant.

4. Dispositif de refroidissement selon la revendication 2 ou 3, **caractérisé en ce que** les parois de séparation (6, 7) sont munies de canaux de refroidissement (8, 14) pour l'amenée de moyen de refroidissement.

5. Dispositif de refroidissement selon l'une des revendications 2 à 4, **caractérisé en ce que** le boîtier (5) est muni de canaux de refroidissement (8, 14) pour l'amenée de moyen de refroidissement.

6. Dispositif de refroidissement selon la revendication 1, **caractérisé en ce que** la partie de puissance (3) et la partie de commande (2) sont disposées spatialement espacées l'une de l'autre.

7. Dispositif de refroidissement selon l'une des revendications précédentes, **caractérisé en ce que** la température d'alimentation du moyen de refroidissement vers la partie de puissance (3) est d'environ 90 degrés Celsius et la température d'alimentation du moyen de refroidissement vers la partie de commande (2) est d'environ 70 degrés Celsius.

8. Dispositif de refroidissement selon l'une de revendications précédentes, **caractérisé en ce que** des éléments de la partie de commande sont disposés dans la zone de la partie de puissance et/ou des éléments de la partie de puissance sont disposés dans la zone de la partie de commande.
